# EUROPEAN PATENT APPLICATION

(11) **EP 2 065 531 A1**
(43) Date of publication of application: **03.06.2009**
(21) Application number: 07425765.0
(22) Date of filing: 30.11.2007
(51) Int. Cl.: E04C 1/42, F24J 2/04, F24J 2/05

(54) **Brick in transparent material**

(71) Applicant: SAVE S.r.l., 46035 Ostiglia (MN) (IT)
(72) Inventor: Lodovico, Eridani Franco, 37121 Verona (IT)
(74) Representative: Fisauli, Beatrice A. M.

(57) **Abstract**

A brick (10) in transparent material such as glass or another similar material has an inner cavity in which solar cells (20) are arranged so as to be irradiated by the light of the sun.

The electric energy obtained from the solar cells of one o more bricks (10) is accumulated in batteries (48) for a subsequent utilization.

The brick has a double function: the structural function and the function of taking advantage of the sun energy to produce electric energy.

## Description

This invention refers to a particular type of brick and to a brick wall, for instance a boundary brick wall, built by utilizing bricks of that particular type. More specifically, this invention relates to a brick and a brick wall, built by utilizing said kind of brick that comprises components that transform and accumulate the sun energy.

As is known, in the building field there is an increasing need of utilizing renewable energy sources. For instance, for the heating of water in a house solar panels are usually mounted on the house roof. Besides, the exploitation of the sun energy is carried out by means of photovoltaic cells that are mounted on the roof or walls of the house.

On the one hand, through said systems it Is possible to obtain, without pollution, an energy such as heat energy, electric energy, that is easy to utilize. On the other hand, said systems need to be arranged on large surfaces.

Disadvantageously, if the solar cells are arranged on the walls of the building, the solar cells prevent the sunbeams to reach the walls. Above all, the solar cells prevent windows or doors to be positioned in the planning phase to allow the light of the sun to pass through.

The aim and object of this invention is to eliminate the above drawbacks by carrying out a brick and a brick wall that take advantage of the energy of the sunbeams passing through the brick itself in order to illuminate rooms with a natural light.

A further object of this invention is to carry out a wall that allows a heat insulation and a soundproofing of the room delimited by said brick wall.

A further object of this invention is to carry out a wall that resists the strains and stresses caused by ground settlings, ground sinkings and earthquake shocks.

The above objects and further ones are achieved by utilizing a brick having a hollow structure in transparent material, which brick is characterized by the fact of receiving in its cavity means that turn the sun energy into heat energy and/or electric energy, including means that transmit the heat energy and/or the electric energy.

Advantageously, the brick is in a transparent material such as silica compounds, plastic materials such as acrylic resins or other materials that allow the sunbeams to pass to the inside of the brick so that the sunbeams reach the means for the transformation of the sun energy.

Said means for the transformation of the sun energy may be either photovoltaic cells that transform the sun energy into electric energy or solar panels (solar collectors) that transform the sun energy into a heat energy. Besides, it is possible to utilize photosynthesis systems as means for the transformation of the sun energy.

In addition, the objects of this invention are reached through a brick wall, built by utilizing the so-described bricks.

Advantageously, since the brick according to this invention is preferably utilized to build the external walls of buildings, vacuum is generated in the inner cavity of each brick in transparent material in order to provide a good heat barrier between the outside and the inside of a house or building.

As an alternative, it is possible to inject an inert gas in the cavity of each brick in order to reach the same result.

Besides, it is possible to obtain a heat insulation by providing means acting as a shield from the sunbeams, for instance particular refracting pellicles, on the innest side of each brick so as to selectively block certain spectra of electro-magnetic radiation (ultraviolet and/or infrared radiation).

The brick wall according to the invention is built by arranging the bricks side by side and in a plurality of brick rows laid one upon the other. In addition, the bricks are fixed to one another through adhesives such as glue.

Advantageously, rubber bars or bars in another material, preferably a fire-retardant material, are inserted between adjacent brick rows, laid one upon the other. Said rubber bars are received in suitable cavities obtained in the bricks. The rubber bars better the resistance to the stresses such as shearing stresses as well as to the stresses caused by settlings, for instance settlings in the building stage, ground sinkings, earthquake shocks. Besides, said rubber bars act as heat cutting elements between the inside and the outside of the building.

As an advantage, a packing in an elastomeric polymer or other material such as PVC may be inserted between adjacent lateral faces of bricks placed side by side. Said packing is received in a suitable seat formed in the same lateral faces of every brick. Said packing also improves the heat insulation and soundproofing of the wall.

The whole wall may be supported by a bearing structure or base that is so shaped to receive the lower part of a row of bricks.

In case the bricks comprise solar cells, said solar cells are connected mutually so as to carry out a circuit, fed by said solar cells.

Advantageously, an accumulator of electric energy may be received in the lower base and is connected to circuit terminals of a circuit comprising photovoltaic cells.

Features and advantages of this invention will be made clearer in the following specification that is supplied as a non-restricting example on the hand of the accompanying drawings, wherein:
- Fig. 1 is an axonometric view of a brick according to this invention;
- Fig. 2 is an axonometric view of a part of a brick wall, built by utilizing brick like that of Fig. 1; and
- Fig. 3 is a side section view along a longitudinal plane of the part of wall of Fig. 2.

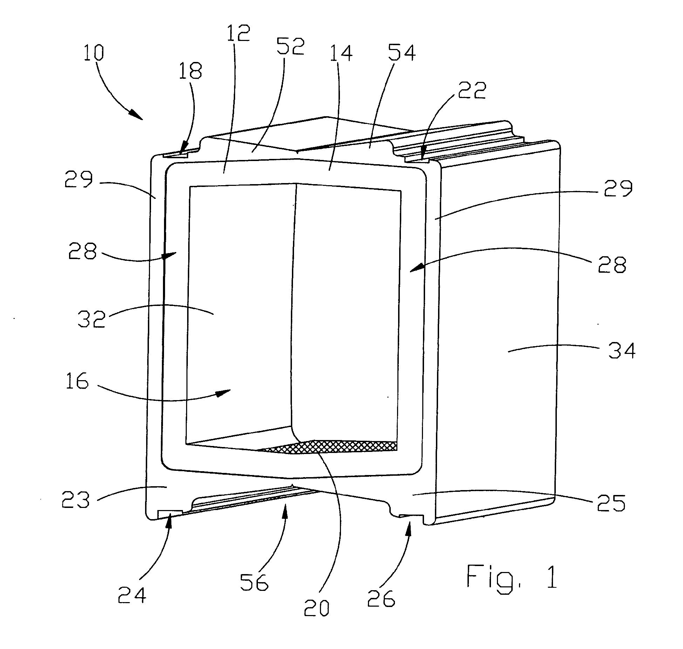

With reference to Figure 1, reference number 10 denotes a brick of glass. This brick is produced by joining together two symmetric U-shaped brick components 12, 14. The two brick components 12, 14 are cold-welded or hot-sealed so as to form a basically parallelepiped-shaped brick. The brick has a through-opening 16.

The brick 10 has a lower part and an upper part. Said parts are connected through side walls 32, 34. More specifically, the side wall 32 is directed toward the outside of the building while the side wall 34 is directed toward the inside of the building.

The lower part of the brick comprises two longitudinal feet 23, 25. A cavity 56 is obtained between said feet.

The upper part of the brick comprises two longitudinal protrusions 52, 54. Each protrusion rests on its respective U-shaped component 12, 14.

Two longitudinal grooves 18, 22 are obtained along the two lateral edges of the upper part of the brick 10. More precisely, the groove 18 is obtained in the U-shaped component 12 and the groove 22 is obtained in the U-shaped component 14.

Likewise, on the lower part of the brick 10 a first groove 24 and a second groove 26 are obtained in the feet 23, 25, respectively.

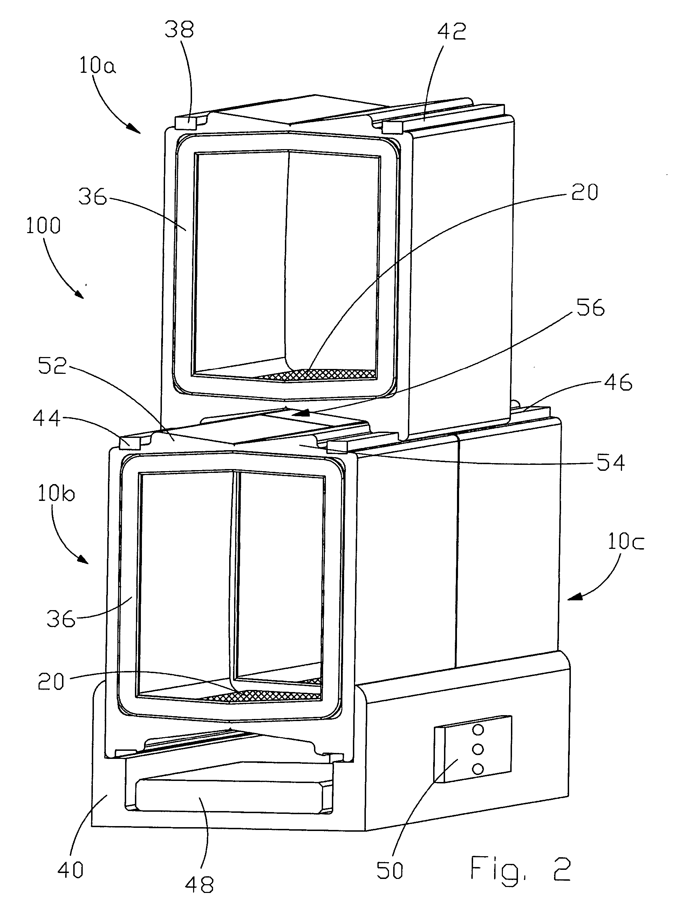

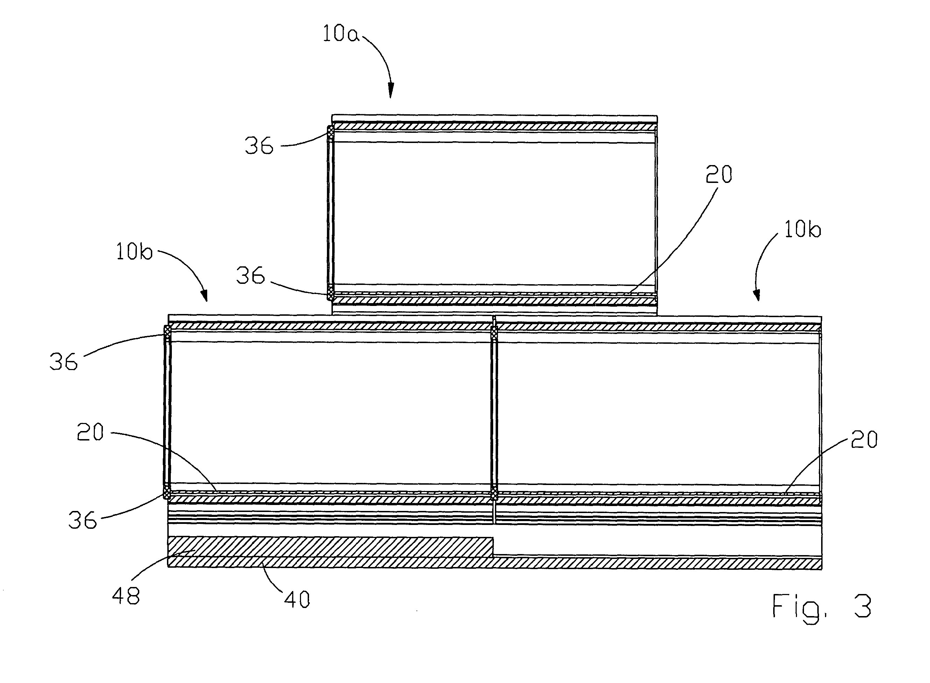

A groove 28 is obtained along a side border 29 that develops along a vertical plane, orthogonally to the side walls 32, 34. Said groove 28 may receive a packing 36 as it can be seen in Figures 2, 3.

A photovoltaic module 20 is laid on the bottom of the opening 16 and comprises photovoltaic cells and suitable terminals for the electric connection.

A refracting pellicle (not represented in the drawings) is placed on the side wall 34. In particular, it is possible to position said refracting pellicle on the inner and/or outer face of the side wall 34. Said refracting pellicle prevents electromagnetic radiations of the spectrum of ultraviolet or infrared radiations to pass through.

In Figures 2, 3, there is represented a brick wall 100 that comprises a plurality of bricks 10 like the so-described brick. The bricks are arranged in rows laid one upon the other. Each row comprises bricks placed side by side.

The portion of wall of Figures 2, 3 has a supporting hollow base 40.

An accumulator 48 for the electric energy is placed on the bottom of said base. In addition, the base 40 comprises an electric plug 50 that is connected with the accumulator 48 directly. A first row 10b, 10c of bricks of the so-described type is jointed or attached onto the supporting hollow base 40. The bricks are arranged side by side and a packing 36 is received in the groove 28 obtained in the side border 29 of each brick so that a packing is interposed between adjacent bricks. The adjacent bricks and the packing 36 are fixed together through suitable known adhesives. The photovoltaic modules 20 of each row are connected to each other in series.

A second row 10a of bricks is placed on the first row 10b, 10c of bricks, only one brick of the second row being represented in the drawing. The protrusions 52, 54 of the lower bricks are received in the cavity 56 of the lower part of the upper bricks. However, a longitudinal passage is let free to allow the insertion of cables and/or leds.

In addition, a first bar 44 and a second bar 46 are arranged in the grooves 18, 22 of the lower bricks, respectively. Said bars 44, 46 are produced in a material such as PVC that has the characteristics of heat insulation and soundproofing. Said bars 44, 46 are put in the grooves 18, 22 of the lower bricks, respectively and are received in the grooves 24, 26 of the upper bricks 10a.

Likewise, the row of the upper bricks has two bars 38, 42 on the upper part to arrange an upper row of bricks (not represented) so that a modular structure is obtained.

The presence of packings 36 and bars 44, 46 improves the characteristics of heat insulation and soundproofing of the wall according to the invention.

Besides, the bars 44, 46 improve the resistance to the strains and stresses of the whole wall. This feature is improved if bars having a metal core such as aluminum are utilized.

The lateral ends of the wall comprise sheathes (not represented) or other means to close the openings 16 of each row of bricks. Conductive means to conduct the electric energy are arranged on said sheathes and connect each row of photovoltaic modules 20 with the accumulator 48. The openings 16 are closed by said sheathes and therefore, it is possible to fill said openings with an inert noble gas. Alternatively, vacuum is generated in said openings in order to improve the heat insulation and soundproofing of the wall.

The so-described wall allows the light of the sun to pass through the bricks and illuminate the inner room. At the same time, the photovoltaic modules of each brick allow to utilize the sun energy that is transformed into electric energy to be accumulated in suitable accumulators.

In addition, the wall acts as a heat insulator and soundproofing barrier thanks to the presence of an inert gas or vacuum in the inside of the bricks, thanks to the pellicle or other refracting means arranged on the innest wall of the bricks and thanks to the bars and packings positioned between the bricks.

A technician of the sector may conceive changes and versions of the so-described, represented brick and wall to obtain solutions that are to be considered as included in the scope of protection of this invention.

For instance, the brick may be closed completely (without through-opening) and have an inner cavity in which a photovoltaic module is received.

As mentioned above, the brick according to this invention may be produced in glass or other materials such as methyl methacrylate polymers or other transparent material.

According to another version of the invention, the wall comprises bricks that are laid side by side and are crossed by solar collectors. The heat energy obtained by utilizing said collectors is used for instance to heat water in the houses or buildings.

Finally, the brick according to this invention may comprise the above-mentioned photosynthesis systems in place of a photovoltaic module.

## Claims

1. Brick (10) comprising a hollow structure (12, 14) in a transparent material, wherein the brick cavity (16) receives means (20) for the transformation of sun energy into a heat energy and/or electric energy, and means for the transmission of the heat energy and/or electric energy.

2. Brick (10) according to claim 1, wherein said means for the transformation of the sun energy are photovoltaic cells (20) comprising terminals for the electric connection.

3. Brick (10) according to claim 1, wherein said means for the transformation of the solar energy is at least a solar collector.

4. Brick (10) according to claim 1, wherein said means for the transformation of the sun energy are photosynthesis systems.

5. Brick (10) according to any of the foregoing claims, **characterized by** the fact of comprising shielding means to shield the sun radiations.

6. Brick (10) according to any of the foregoing claims, wherein in said cavity vacuum has been created.

7. Brick (10) according to any of claims 1-5, wherein said cavity is filled with an inert gas.

8. Brick wall (100), built with bricks (10) according to the foregoing claims.

9. Brick wall (100) according to claim 8, wherein the bricks (10) are laid side by side and are laid one upon the other, said brick being secured to each other through fixing means.

10. Brick wall (100) according to claims 8 or 9, wherein the means (20) of each brick for the transformation of sun energy into heat energy and/or electric energy are connected with each other.

11. Wall (100) according to claim 9 or 10, wherein a packing (36) is arranged between two adjacent brick faces in mutual contact of two adjacent bricks.

12. Wall (100) according to any of claims 9-11, wherein at least a bar (38, 42, 44, 46) is arranged between bricks (10), laid one upon the other, in order to absorb the structural stresses.

13. Wall (100) according to any of claims 8-12, wherein a bearing structure (40) is arranged under the lowest row of bricks.

14. Wall (100) according to any of claims 9-13, wherein means (48) are provided to store up the heat energy and/or the electric energy and said means (48) are connected with the means (20) of at least one brick for the transformation of the sun energy.

15. Wall (100) according to claim 14, wherein the means of accumulation (48) are received in the bearing structure (40).
